# EUROPEAN PATENT SPECIFICATION

(11) **EP 0 759 630 B1**
(45) Date of publication and mention of the grant of the patent: **12.01.2000**
(21) Application number: 96401707.3
(22) Date of filing: 31.07.1996
(51) Int. Cl.: H01H 85/046, H01H 85/20, H01H 69/02, H01R 31/08

(54) **Card-type terminal**
Klemme in Kartenbauart
Borne du type à carte

(30) Priority: 01.08.1995 JP 21661995
(43) Date of publication of application: 26.02.1997
(73) Proprietor: SUMITOMO WIRING SYSTEMS, LTD., Yokkaichi City Mie 510 (JP)
(72) Inventor: Tanigawa, Hidemi, c/o Sumimoto Wiring Syst., Ltd., Yokkaichi-city, Mie 510 (JP)
(74) Representative: Bertrand, Didier

(56) References cited:
- EP-A- 0 002 266
- FR-A- 2 530 074
- JP-U- 56 038 959
- US-A- 3 585 556

## Description

The present invention relates to a card-type terminal to be used in cooperation with a socket which includes a counter-part electrical terminal. The card-type terminal comprises at least one electrical conductor installed on the surface of a board. When the conductor is made of copper or a similar metal, the card-type terminal serves to configure various circuit systems by connecting or disconnecting part of the systems and by modifying the circuits to be used. The conductor may also be a fusible cut-out element.

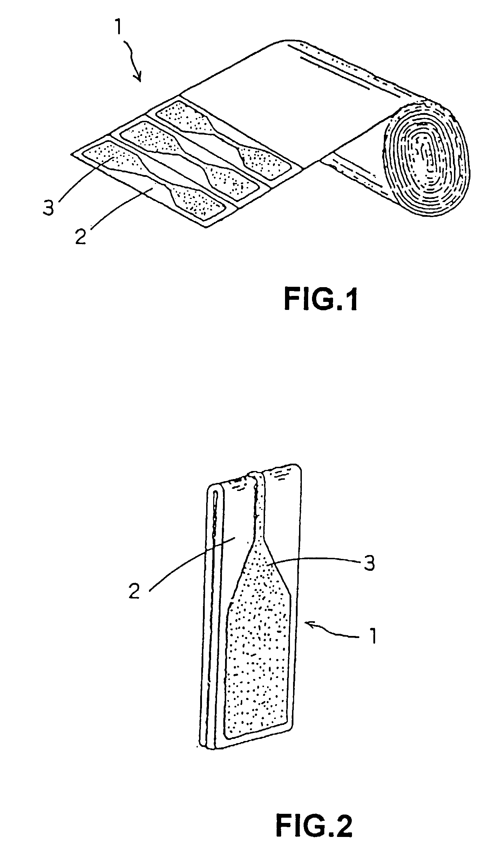

Figures 1 and 2 show a board containing a fusible cut-out element, commonly called a "plate-shaped fuse", disclosed in published JP-U-56038959 (Japanese utility model application Sho 56-38959). This fuse constitutes one type of card-type terminal.

Such a fuse 1 consists of a thin and fusible cut-out sheet 3 serving as an electrical conductor formed on the surface of an insulation substrate 2. The fuse 1 is folded widthways at its center to present a pair of parallel and outwardly facing contacts 3 at its terminal ends, as shown in figure 2, for insertion in a socket. The socket includes pairs of metallic terminal parts facing each other so as to define a slit-shaped aperture adapted to receive the corresponding terminal end of the fuse 1. When the plate-shaped fuse 1 is inserted into the socket, it is interposed between the pairs of metallic terminal parts, thereby forming an electric circuit through the thin and fusible cut-out sheet. When an electric current flows through such a circuit and exceeds a predetermined intensity, the thin sheet 3 is fusion-cut by the heat generated.

With the above-mentioned plate-shaped fuse, the following phenomenon occurs: the fuse is forcibly inserted between the confronting metallic terminal parts of the socket, and then retrieved therefrom. For each such action, the metallic terminal parts mount on the end portion of the thin and fusible cut-out sheet 3 and rub along its surface. By repeating this operation, the end portion gradually becomes susceptible to peeling off.

In view of the above considerations, the present invention has for object to provide a board comprising at least one electrical conductor, commonly called a "card-type terminal", the insertion side of which is constructed so as to reduce the susceptibility to peeling.

To solve the above-mentioned problem, the invention provides a card-type terminal for use in cooperation with a socket having an electrically connecting terminal, the card-type terminal comprising:
a) a substantially rectangular insulation board having a first face and a second back-side face, the board being comprised of a foot portion by which the card-type terminal is inserted into the socket, a head portion, and an intermediate body section, each of the first and second faces being provided with at least one groove extending from the foot portion to the head portion at the corresponding positions on each face;
b) at least one electrical conductor, having two ends, provided inside the groove, the conductor extending along the first and second faces, through being bent around at the head portion, such that each of the ends is located at the foot portion or the intermediate body section of each said face; and,
c) a protective means protecting at least the ends of the electrical conductor.

Preferably, each end of at least one electrical conductor extends to the foot portion.

The protective means may be a covering element. One such element is a channel member having a U-shaped cross-section.

As a variant, the protective means may be a coating.

The protective means may cover not only the foot portion but also the area extending substantially therefrom into the intermediate body section.

In another embodiment, the protective means comprises a pair of protective plates, each plate being configured so as to cover a substantial part of one of the two faces of the board, such that the ends of at least one electrical conductor are also covered, each of the plates having a substantially rectangular opening at the central area thereof, through which an electrical connection can be effected.

In the first embodiment and its variants, the terminal may further comprise a pair of protective plates covering at least a part of the intermediate body section, such that an area between the protective means and the protective plate provides an opening for electrical connection.

In all the above embodiments and variants, the card-type terminal may further comprise a cap applied to the head portion. In this case, the cap can cover a part of the pair of protective plates.

In a preferred variant, the electrical conductor is adhered inside the groove by means of an adhesive agent.

Further, the electrical conductor may be a fusible cut-out element.

There is also provided a method of manufacturing a card-type terminal for use in cooperation with a socket having an electrically connecting terminal, the method comprising the steps of:
a) providing a substantially rectangular first insulation plate having first and second faces, longitudinal sides and lateral sides;
b) providing in the plate a central folding line extending between the longitudinal sides and being parallel to the lateral sides;
c) forming an elongated opening within the plate, the opening extending over a substantial portion of the central folding line;
d) forming at least one groove on the first face extending from one lateral side to the other lateral side and being substantially parallel to the longitudinal sides, the groove intersecting the elongated opening;
e) providing at least one electrical conductor having two ends and a central portion;
f) fixing the electrical conductor within the groove so that the ends of the electrical conductor are placed near the lateral sides of the plate and the central portion of the electrical conductor extends over the elongated opening;
g) folding the first plate, together with at least one electrical conductor, along the central folding line, such that each half of the second face is opposingly stacked, whereby there is formed a board comprised of: a foot portion, including the lateral sides of the first plate, by which the card-type terminal is inserted into the socket, a head portion including the elongated opening, and an intermediate body section; and,
h) applying a protective means to the foot portion.

The method may further comprise the steps of providing a substantially rectangular, comparatively small, second insulation plate with hinge portions on one of each longitudinal side faces on both sides of the central line, folding the second plates onto each side of the first face and fixing the second plates thereupon, thereby forming protective plates applied to the body section.

The first insulation plate and the second insulation plates may be provided as a unitary member.

The method may further comprise a step of providing a cap on the head portion.

In the above embodiments and variants, the end portion of at least one electrical conductor is protected by a protective means such as a cover, so that, when the metallic terminal parts of the socket contact with the board and are mounted on the electrical conductor of the board, the metallic parts first ride on the protective means, then slide down onto the electrical conductor. In this configuration, the metallic parts do not abut against the end portion of the electrical conductor.

Usually, when electrical conductors are adhered and fixed to the surface of the board and the metallic parts mount onto the edge of the board, an adhesive layer may tend to be shifted by the pushing force of the metallic parts exerted on the edge due to its extensible nature. However, in the structure of the invention, the metallic parts first mount on the protective means fitted on the end portion of the board and slide down therefrom onto the electrical conductors, so that the exertion of such a damaging force on the end portion is avoided.

Further, when the electrical conductors are fusible cut-out elements and the metallic parts mount onto them, the fusible cut-out elements tend to be deformed and shifted by the pushing force of the metallic parts due to their ductile nature. This drawback of the known plate-shaped fuse is also eliminated.

In the card-type terminal of the invention, it is the protective cover which receives a mechanical shock and not the electrical conductors. The invention thus provides a card-type terminal in which the electrical conductors are less likely to peel off.

The electrical conductors, including fusible cut-out elements, may be made even less prone to peeling-off by adhering them to the board.

Further, the end portion of the electrical conductors may also be protected by simply applying a coating material to that part. In particular, when the electrical conductors are installed up to the end of the board, a simple dipping of the end portion, including a part of the electrical conductors, in a coating material solution will easily form an adequate protective layer.

The above and other objects, features and advantages will be made apparent from the following description of the preferred embodiments, given as a non-limiting example, with reference to the accompanying drawings, in which
Figure 1 shows a manufacturing process of a known plate-shaped fuse in the course of its manufacturing process;
Figure 2 shows the known product in its final form;
Figure 3 shows the card-type terminal according to a first embodiment of the invention;
Figure 4 shows a first insulation plate with grooves and second insulation plates before having been formed into a board of the above embodiment;
Figure 5 shows the board according to the above embodiment equipped with protective plates and a cap;
Figure 6 shows the board of Figure 5 before a protective cover has been fitted;
Figure 7 shows a second embodiment of the invention according to which a protective means is provided by coating;
Figure 8 shows the card-type terminal protected by a coating;
Figure 9 shows further a third embodiment of the invention according to which the protective plates are provided with an opening through which an electrical connection is effected;
Figure 10 shows a socket with which the card-type terminal of the invention cooperates; and
Figure 11 shows an elevational lateral view of the card-type terminal of the invention, when it is fitted into the socket.

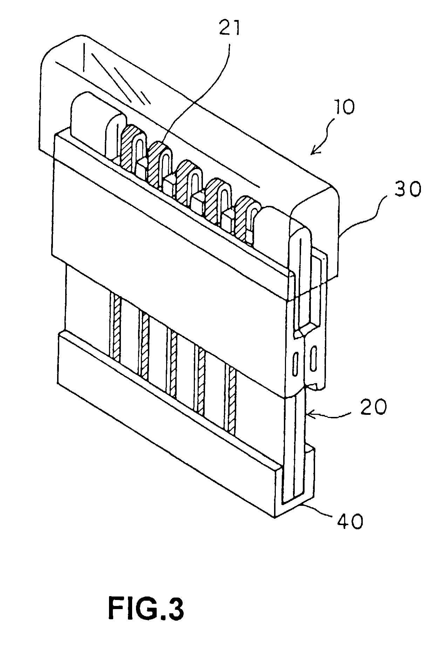

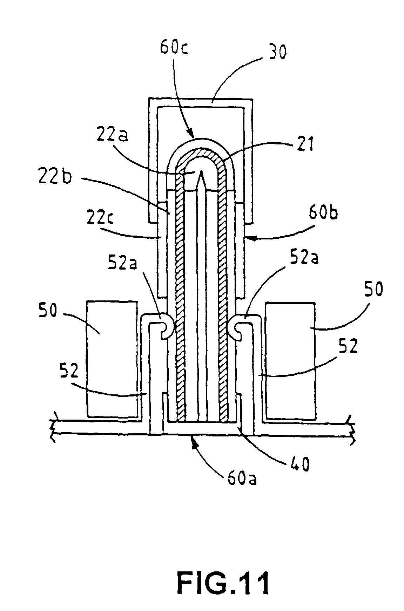

Figure 3 shows a perspective view of a fuse in the form of a card-type terminal according to a first embodiment of the invention. The fuse 10 of this embodiment comprises a board 20; fusible cut-out elements 21 serving as electrical conductors and arranged on two faces of the board 20; a transparent cap 30 covering an end face (corresponding to head portion 60c in figure 11) of the board 20; and a protective cover 40 protecting another end face (corresponding to foot portion 60a in figure 11), distal to the head portion, of the board 20.

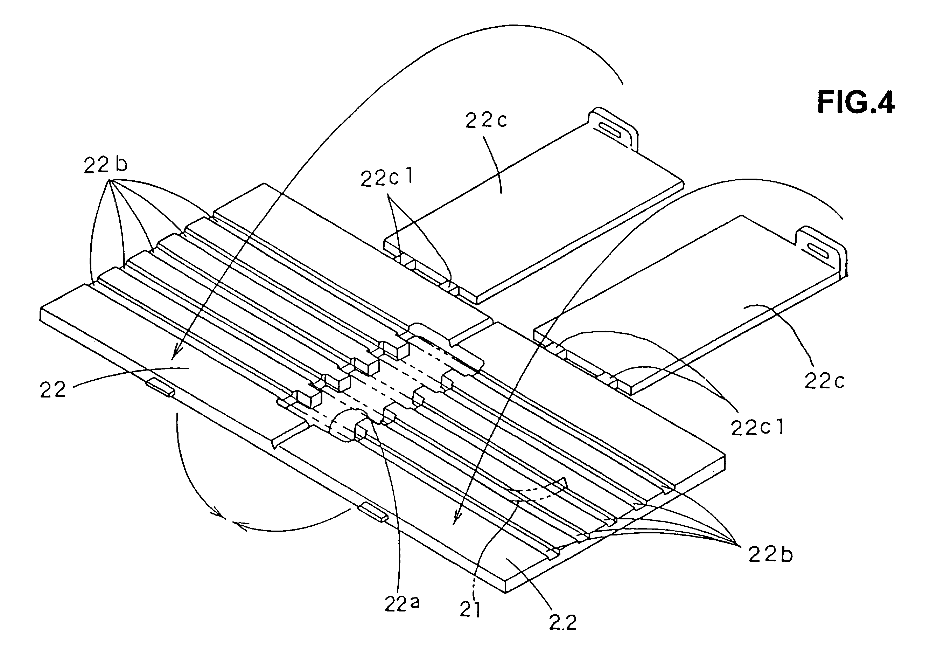

Figure 4 shows an assembling process for the board 20. A rectangular insulation plate 22 is initially prepared. The plate 22 is provided with an opening 22a located at the center area in the longitudinal direction, the opening extending over a substantial portion of the transversal direction. The plate 22 is also provided on a first face with five parallel shallow grooves 22b running along the longitudinal direction, such that the grooves 22b extend from the sides of the opening 22a. One longitudinal side of the insulation plate 22 is connected to a pair of protective plates 22c by means of comparatively thin hinge parts 22c1. The protective plates 22c can be folded onto the surface of the insulation plate 22 by pivoting on the hinge parts, thereby protecting the body section 60b of the board 20 (figure 11).

Fusible cut-out elements 21 in a band or strip shape are adhered by an adhesive agent into the shallow grooves 22b on the insulation plate 22. The latter is folded over on itself along an axis extending across the opening 22a, so as to form a board 20, with the face comprising the fusible elements 21 lying outside. Each of the protective plates 22c is bent onto the corresponding outside face of the board 20 by pivoting on the hinge parts 22c1, such that each protective plate 22c is superposed onto the corresponding fusible element-comprising face of the board 20.

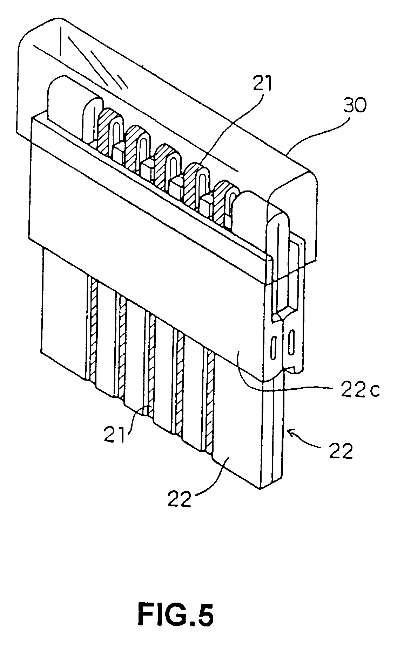

To protect the fusible elements 21 arranged in the opening 22a, the head portion of the board 20 is subsequently covered with a transparent cap 30, as shown in Figure 5.

The transparent cap may cover a part of the protective plates 22c, so that the latter are prevented from opening accidentally.

The above embodiment shows a plate-like fuse 10 formed as a card-type terminal. However, the fuse may be of any shaped material containing at least one electrical conductor which, when inserted into a socket containing metallic terminal parts, is mounted by those metallic parts, so as to establish an electric contact. The fuse may therefore resemble a printed circuit board or a plate-like unit. The fuse may also be in the form of a board projecting from the end portion of an apparatus and serving as a terminal part thereof.

Furthermore, the above embodiment uses strip-shaped fusible elements 21 adhered to the inside surface of a groove by means of an adhesive agent, thereby forming electrical conductors. Although the way of setting up the electrical conductors is not limited to the above method, it is recommended for protecting the end portion of the electrical conductors which are liable to peeling off.

Protecting the end portion of such electrical conductors consequently enables the protection of the whole conductor.

In the above embodiment, the electrical conductor does not necessarily have to be formed up to the edge of the board and the number of electrical conductors can be selected to suit particular requirements.

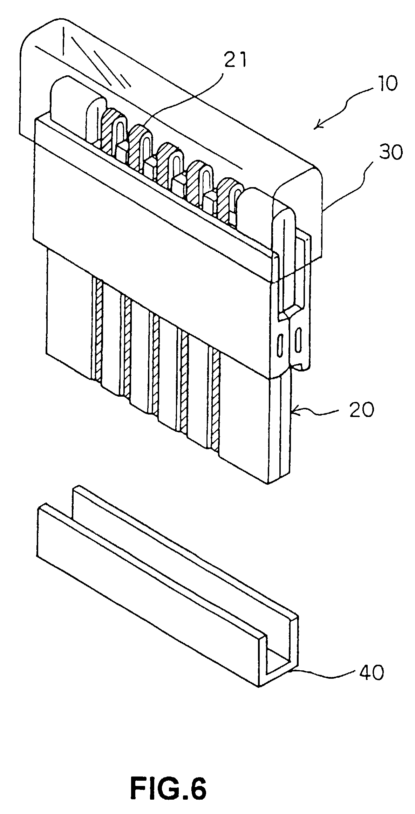

After the board 20 has been constructed, its foot portion 60a is protected by a cover 40 which is a channel having a substantially U-shaped cross-section, as shown in figure 6.

The fusible elements 21 are then installed up to the foot portion of the board 20, so that, when the protective cover 40 is applied from the foot portion 60a to cover the two faces of the board 20, it also covers the end portion of the fusible elements. The protective cover 40 is fixed to the board 20 by means of an adhesive agent.

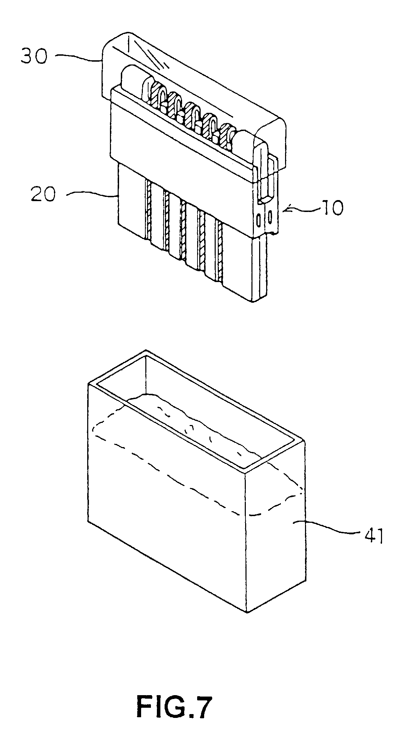

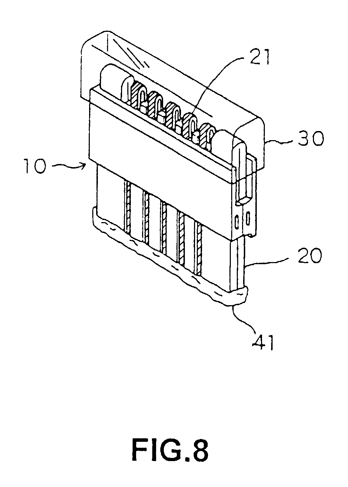

In the above embodiment, the protective cover 40 is fitted onto the foot portion 60a of the board 20, so as to protect the end portion of the electrical conductors. However, the protective means is not necessarily limited to such a shaped cover: as shown in Figures 7 and 8, the foot portion 60a of the board 20 may merely be dipped in a coating agent 41, thereby providing a protective coating.

When the protective cover 40 is used, the adhesive agent may be contained inside the cover, which facilitates drying during the manufacturing process. Adversely, the use of such an additional cover raises unit cost and tends to increase the size.

On the other hand, when a coating agent 41 is applied, the cost is relatively low and a thin film is easily obtained. However, the drying operation is more difficult to carry out during the manufacturing process.

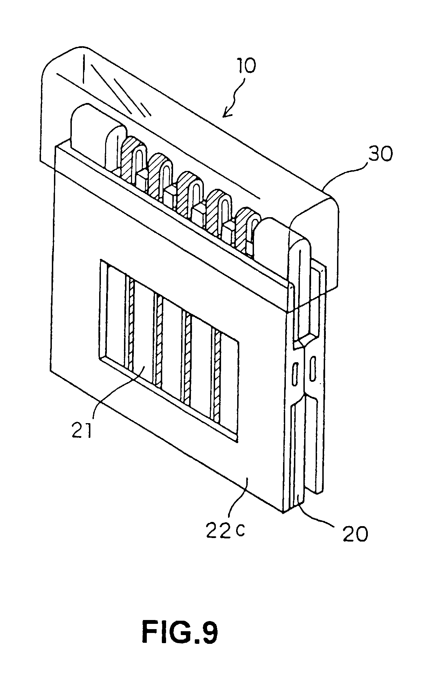

Although, the fusible element 21 is extended up to the foot portion 60a of the board 20 in the above embodiments, it can alternatively be formed only up to about half way towards the foot portion. In such a case, either a coating agent 41 may be applied to this half-way area or, as shown in Figure 9, the protective plate 22d may be constructed such that it covers a major part of the board 20 and such that the center area of the body protective plate 22d is provided with an opening communicating with the outside. In the case where the electrical conductors extend up to the foot portion 60a of the board 20, the protective plate 22d with the opening may be extensively constructed so as to serve as a protective cover for the foot portion 60a.

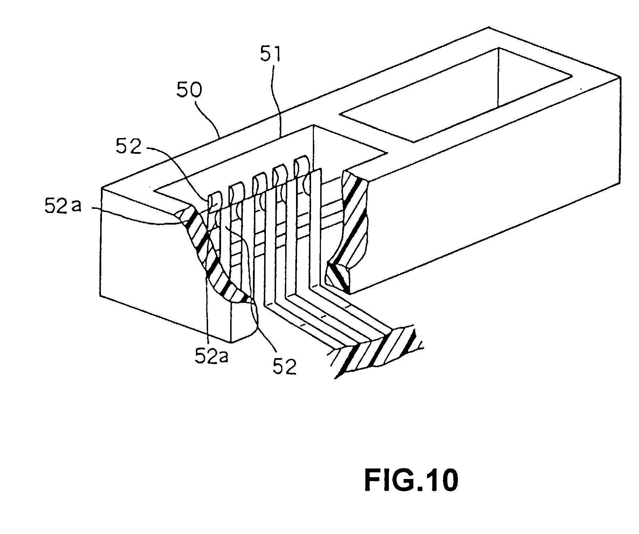

Figure 10 shows a socket 50 provided with a slit-shaped insertion aperture 51 located on its top side (as seen in figure 10) through which the plate-like fuse 10 of the invention is inserted.

The inside of the insertion aperture 51 includes, pairs of facing metallic terminal parts 52, which are adapted to receive the fuse between them.

Each of the metallic terminal parts 52 has the shape of a band or strip, the upper end of which (as seen in Figure 10) is bent to form a lug of circular cross-section protruding towards the fuse insertion side of the terminal parts 52, thereby forming a contacting lug 52a. This construction provides flexural rigidity in a direction perpendicular to that in which the fuse 10 is inserted.

As the contacting lugs 52a project towards the fuse-insertion side in the aperture 51, the lugs 52a ride on the fusible elements 21, serving as electrical conductors, upon insertion of the fuse, thereby establishing an electric contact.

The functional aspects of the above embodiments shall now be described.

The fuse 10 is inserted, from its foot portion end, into the insertion aperture 51 of the socket 50. Then, the contacting lugs 52a of the metallic terminal parts 52 abut against the outermost square edge of the protective cover 40 provided on the foot-portion side of the fuse 10 and ride on the cover 40.

By further pushing the fuse 10, the lug portions 52a slide onto the protective cover 40 and, going beyond the cover edge, proximal to the head portion of the board 20, slide down onto the fusible elements 21. By virtue of this mechanism, no force is exerted on the edge portion of the fusible elements 21. Moreover, when crossing the cover edge, the contacting lugs 52a go down onto the surface of the fusible elements 21 in a natural manner, so that the latter receives a negligible impact and thus is not exposed to the risk of peeling.

## Claims

1. A card-type terminal (10) for use in cooperation with a socket (50) having an electrically connecting terminal (52), said card-type terminal (10) comprising a substantially rectangular insulation board (20) having a first face and a second back-side face, said board (20) being comprised of a foot portion (60a) by which said card-type terminal (10) is inserted into said socket (50), a head portion (60c), and an intermediate body section (60b),
characterised in that
a) each of said first and second faces is provided with at least one groove (22b) extending from said foot portion to said head portion at the corresponding positions on each face;
b) at least one electrical conductor (21), having two ends, is provided inside said groove (22b), said conductor (21) extending along said first and second faces, through being bent around at said head portion (60c), such that each of said ends is located at said foot portion (60a) or said intermediate body section (60b) of each said face; and,
c) a protective means (40) protects at least said two ends of the electrical conductor (21).

2. A card-type terminal (10) according to claim 1, wherein each end of said at least one electrical conductor (21) extends to said foot portion (60a).

3. A card-type terminal (10) according to claim 1 or 2, wherein said protective means is a covering element.

4. A card-type terminal (10) according to claim 3, wherein said covering element is a channel member having a U-shaped cross-section.

5. A card-type terminal (10) according to claim 3, wherein said protective means (40) is a coating (41).

6. A card-type terminal (10) according to any one of claims 1 to 5, wherein said protective means (40) further covers an area extending substantially therefrom into said intermediate body section (60b).

7. A card-type terminal (10) according to claim 1 or 2, wherein said protective means (40) comprises a pair of protective plates (22d), each plate being configured so as to cover a substantial part of one of said two faces of said board (20), such that said ends of said at least one electrical conductor (21) are also covered, each of said plates (22d) having a substantially rectangular opening at the central area thereof, through which an electrical connection can be effected.

8. A card-type terminal (10) according to any one of claims 1 to 6, further comprising a pair of protective plates (22c) covering at least a part of said intermediate body section (60b), such that an area between said protective means (40) and said protective plate (22c) provides an opening for electrical connection.

9. A card-type terminal (10) according to any one of claims 1 to 8, further comprising a cap (30) applied to said head portion (60c).

10. A card-type terminal (10) according to claim 7 or 8, further comprising a cap (30) applied to said head portion (60c), whereby said cap (30) covers a part of said pair of protective plates (22c, 22d).

11. A card-type terminal (10) according to any one of claims 1 to 10, wherein said at least one electrical conductor (21) is adhered inside said groove (22b) by means of an adhesive agent.

12. A card-type terminal (10) according to any one of claims 1 to 11, wherein said at least one electrical conductor (21) is a fusible cut-out element.

13. A method of manufacturing a card-type terminal (10) according to claims 1-12 for use in cooperation with a socket (50) having an electrically connecting terminal (52), characterised in that said method comprises the steps of:
a) providing a substantially rectangular first insulation plate (22) having first and second faces, longitudinal sides and lateral sides;
b) providing in said plate (22) a central folding line extending between said longitudinal sides and being parallel to said lateral sides;
c) forming an elongated opening (22a) within said plate (22), said opening (22a) extending over a substantial portion of said central folding line;
d) forming at least one groove (22b) on said first face extending from one lateral side to the other lateral side and being substantially parallel to said longitudinal sides, said groove (22b) intersecting said elongated opening (22a);
e) providing at least one electrical conductor (21) having two ends and a central portion;
f) fixing said electrical conductor (21) within said groove so that said ends of the electrical conductor (21) are placed near said lateral sides of the plate (22) and said central portion of the electrical conductor (21) extends over said elongated opening (22a);
g) folding said first plate (22), together with said at least one electrical conductor (21), along said central folding line, such that each half of said second face are opposingly stacked, whereby there is formed a board (20) comprised of: a foot portion (60a), including said lateral sides of the first plate (22), by which said card-type terminal is inserted into said socket (50), a head portion (60c) including said elongated opening (22a), and an intermediate body section (60b); and,
h) applying a protective means (40) to said foot portion (60a).

14. A method of manufacturing a card-type terminal (10) according to claim 13, further comprising the steps of providing a substantially rectangular, comparatively small, second insulation plate (22c) with hinge portions (22c1) on one of each longitudinal side face on both sides of said central line, folding said second plates (22c) onto each side of said first face and fixing said second plates (22c) thereupon, thereby forming protective plates (22c, 22d) applied to said body section (60b).

15. A method of manufacturing a card-type terminal (10) according to claim 14, wherein said first insulation plate (22) and said second insulation plates (22c) are provided as a unitary member.

16. A method of manufacturing a card type terminal (10) according to any one of claims 13 to 15, wherein said method further comprises a step of providing a cap (30) on said head portion (60c).

## Patentansprüche

1. Kartentypklemme bzw. -anschluß (10) zur zusammenwirkenden Verwendung mit einem Sockel (50), welcher einen elektrisch verbindenden Anschluß (52) aufweist, wobei der Kartentypanschluß (10) eine im wesentlichen rechteckige Isolierplatte bzw. -karte (20) mit einer ersten Fläche und einer zweiten rückwärtigen Fläche umfaßt, die Karte (20) einen Fußabschnitt (60a), mittels welchem der Kartentypanschluß (10) in den Sockel (50) eingeführt wird, einen Kopfabschnitt (60c) und einen Zwischenkörperbereich bzw. -abschnitt (60b) umfaßt, dadurch gekennzeichnet, daß
(a) jede der ersten und zweiten Fläche mit zumindest einer Ausnehmung bzw. Nut (22b) bereitgestellt ist, welche sich von dem Fußabschnitt zu dem Kopfabschnitt bei den entsprechenden Positionen an bzw. auf jeder Fläche erstreckt;
(b) zumindest ein elektrischer Leiter (21), welcher zwei Enden aufweist, in der Nut (22b) bereitgestellt ist, der Leiter (21) sich entlang der ersten und zweiten Fläche erstreckt und um den Kopfabschnitt (60c) herumgekrümmt ist, so daß jedes seiner Enden bei dem Fußabschnitt (60a) oder dem Zwischenkörperabschnitt (60b) von jeder der Flächen angeordnet ist; und
(c) ein Schutzmittel bzw. -einrichtung (40) zumindest die zwei Enden des elektrischen Leiters (21) schützt.

2. Kartentypanschluß (10) nach Anspruch 1, wobei jedes Ende des zumindest einen elektrischen Leiters (21) sich zu dem Fußabschnitt (60a) erstreckt.

3. Kartentypanschluß (10) nach Anspruch 1 oder 2, wobei die Schutzeinrichtung ein Abdeckelement ist.

4. Kartentypanschluß (10) nach Anspruch 3, wobei das Abdeckelement ein Rinnen- bzw. Kanalelement mit einem U-förmigen Querschnitt ist.

5. Kartentypanschluß (10) nach Anspruch 3, wobei die Schutzeinrichtung (40) eine Beschichtung (41) ist.

6. Kartentypanschluß (10) nach einem der Ansprüche 1 bis 5, wobei die Schutzeinrichtung (40) weiter eine Fläche bzw. einen Bereich abdeckt, welcher sich im wesentlichen von dort in den Zwischenkörperabschnitt (60b) erstreckt.

7. Kartentypanschluß (10) nach Anspruch 1 oder 2, wobei die Schutzeinrichtung (40) ein Paar von Schutzplatten (22d) umfaßt, wobei jede Platte derart aufgebaut bzw. konfiguriert ist, daß sie einen wesentlichen Teil von einer der beiden Flächen der Karte (20) abdeckt, so daß die Enden des zumindest einen elektrischen Leiters (21) ebenfalls abgedeckt sind, wobei die Platten (22d) eine im wesentlichen rechtecksförmige Öffnung an dessen zentraler Fläche aufweisen, durch welche eine elektrische Verbindung bewirkt werden kann.

8. Kartentypanschluß (10) nach einem der Ansprüche 1 bis 6 mit einem Paar von Schutzplatten (22c), welche zumindest einen Teil des Zwischenkörperabschnitts (60b) abdecken, so daß eine Fläche zwischen der Schutzeinrichtung (40) und der Schutzplatte (22c) eine Öffnung für eine elektrische Verbindung bereitstellt.

9. Kartentypanschluß (10) nach einem der Ansprüche 1 bis 8 mit einem Deckel bzw. einer Kappe (30), welche auf den Kopfabschnitt (60c) angewendet bzw. angebracht bzw. aufgesetzt ist.

10. Kartentypanschluß (10) nach Anspruch 7 oder 8 mit einem Deckel bzw. einer Kappe (30), welche zu bzw. auf den Kopfabschnitt (60c) angewendet bzw. angebracht bzw. aufgesetzt ist, wodurch die Kappe (30) einen Teil des Paares von Schutzplatten (22c, 22d) abdeckt.

11. Kartentypanschluß (10) nach einem der Ansprüche 1 bis 10, wobei der zumindest eine elektrische Leiter (21) innerhalb der Nut (22b) mittels eines Klebstoffs angeklebt ist.

12. Kartentypanschluß (10) nach einem der Ansprüche 1 bis 11, wobei der zumindest eine elektrische Leiter (21) ein schmelzbares, ausgeschnittenes Element bzw. Ausschnittselement ist.

13. Verfahren zum Herstellen einer Kartentypklemme bzw. eines Kartentypanschlusses (10) nach einem der Ansprüche 1 bis 12 zur Verwendung in Zusammenwirkung mit einem Sockel (50), welcher einen elektrisch verbindenden Anschluß bzw. Verbindungsanschluß (52) aufweist, dadurch gekennzeichnet, daß das Verfahren die folgenden Schritte umfaßt:
(a) Bereitstellen einer im wesentlichen rechteckigen ersten Isolierplatte (22) mit einer ersten und zweiten Fläche, longitudinalen und lateralen Seiten;
(b) Bereitstellen einer mittigen bzw. zentralen Faltlinie in der Platte (22), welche sich zwischen den longitudinalen Seiten erstreckt und parallel zu den lateralen Seiten ist;
(c) Bilden einer länglichen Öffnung (22a) in der Platte (22), wobei die Öffnung (22a) sich über einen wesentlichen Abschnitt der mittigen Faltlinie erstreckt;
(d) Bilden von zumindest einer Ausnehmung bzw. Nut (22b) an der ersten Fläche, welche sich von einer lateralen Seite zu der anderen lateralen Seiten erstreckt und im wesentlichen parallel zu den longitudinalen Seiten ist, wobei die Nut (22b) die längliche Öffnung (22a) schneidet;
(e) Bereitstellen von zumindest einem elektrischen Leiter (21), welcher zwei Enden und einen mittigen bzw. zentralen Abschnitt aufweist;
(f) Befestigen des elektrischen Leiters (21) innerhalb der Nut, so daß die Enden des elektrischen Leiters (21) nahe den lateralen Seiten der Platte (22) angeordnet sind und der zentrale Abschnitt des elektrischen Leiters (21) sich über die längliche Öffnung (22a) erstreckt;
(g) Falten der ersten Platte (22) gemeinsam mit dem zumindest einen elektrischer Leiter (21) entlang der mittigen Faltlinie, so daß jede Hälfte der zweiten Fläche einander entgegengesetzt bzw. gegenüberliegend bzw. umgekehrt gestapelt ist, wodurch eine Platte bzw. Karte (20) gebildet wird, welche einen Fußabschnitt (60a), welcher die lateralen Seiten der erste Platte (22) beinhaltet, durch welchen der Kartentypanschluß in den Sockel (50) eingeführt wird, einen Kopfabschnitt (60c), welcher die längliche Öffnung (22a) beinhaltet, und einen Zwischenkörperabschnitt (60b) umfaßt; und
(h) Anwenden eines Schutzmittels bzw. -einrichtung (40) auf den Fußabschnitt (60a).

14. Verfahren zum Herstellen eines Kartentypanschlusses (10) nach Anspruch 13 mit den Schritten eines Bereitstellens einer im wesentlichen rechteckigen, vergleichsweise kleinen zweiten Isolierplatte (22c) mit Scharnier- bzw. Drehgelenksabschnitten (22c1) an eine von jeder longitudinalen Seitenfläche an bzw. auf beiden Seiten der mittigen Linie, Falten der zweiten Platten (22c) auf jede Seite der ersten Fläche und Befestigen der zweiten Platten (22c) daran, wodurch Schutzplatten (22c, 22d), die an den Körperabschnitt (60b) angeordnet bzw. angebracht werden, gebildet werden.

15. Verfahren zum Herstellen eines Kartentypanschlusses (10) nach Anspruch 14, wobei die erste Isolierplatte (22) und die zweiten Isolierplatten (22c) als ein unitäres Bauteil bereitgestellt sind.

16. Verfahren zum Herstellen eines Kartentypanschlusses (10) nach einem der Ansprüche 13 bis 15, wobei das Verfahren weiter einen Schritt eines Bereitstellens eines Deckels bzw. einer Kappe (30) an bzw. auf dem Kopfabschnitt (60c) umfaßt.

## Revendications

1. Elément de connexion du type carte (10) destiné à être utilisé en coopération avec un élément femelle (50) comportant une borne de connexion électrique (52), l'élément de connexion du type carte (10) comprenant une plaque isolante (20) sensiblement rectangulaire présentant une première face est une seconde face formant face arrière, la plaque (20) étant constituée d'une partie de pied (60a) par laquelle l'élément de connexion de type carte (10) est inséré dans l'élément femelle (50), une partie de tête (60c) et une section de corps intermédiaire (60b),
caractérisé en ce que
a) chacune des première et seconde faces est pourvue d'au moins une rainure (22b) s'étendant de la partie de pied à la partie de tête en des positions se correspondant sur chaque face ;
b) au moins un conducteur électrique (21), présentant deux extrémités, est prévu dans la rainure (22b), le conducteur (21) s'étendant le long des première et seconde faces par l'intermédiaire d'un pliage autour de la partie de tête (60c), de façon que chacune des extrémités soit située à l'endroit de la partie de pied (60a) ou de la section de corps intermédiaire (60b) de chaque face ; et,
c) des moyens de protection (40) protègent au moins les deux extrémités du conducteur électrique (21).

2. Elément de connexion du type carte (10) suivant la revendication 1, dans lequel chaque extrémité du ou de chaque conducteur électrique (21) s'étend jusqu'à la partie de pied (60a).

3. Elément de connexion du type carte (10) suivant la revendication 1 ou 2, dans lequel les moyens de protection consistent en un élément de recouvrement.

4. Elément de connexion du type carte (10) suivant la revendication 3, dans lequel l'élément de recouvrement est une pièce en forme de gouttière ayant une section transversale en U.

5. Elément de connexion du type carte (10) suivant la revendication 3, dans lequel les moyens de protection (40) consistent en un revêtement (41).

6. Elément de connexion du type carte (10) suivant l'une quelconque des revendications 1 à 5, dans lequel les moyens de protection (40) recouvrent en outre une zone s'étendant sensiblement à partir de là jusque dans la section de corps intermédiaire (60b).

7. Elément de connexion du type carte (10) suivant la revendication 2, dans lequel les moyens de protection (40) comprennent deux plaquettes protectrices (22d), chaque plaquette étant conformée de manière à recouvrir une partie notable de l'une des deux faces de la plaque (20), de façon que les extrémités du ou de chaque conducteur électrique (21) soient aussi recouvertes, chacune des plaquettes (22d) présentant dans sa zone centrale une ouverture sensiblement rectangulaire par laquelle une connexion électrique peut être réalisée.

8. Elément de connexion du type carte (10) suivant l'une quelconque des revendications 1 à 6, comprenant en outre deux plaquettes protectrices (22c) recouvrant au moins une partie de la section de corps intermédiaire (60b), de façon qu'une zone située entre les moyens de protection (40) et la plaquette de protection (22c) fournisse une ouverture pour une connexion électrique.

9. Elément de connexion du type carte (10) suivant l'une quelconque des revendications 1 à 8, comprenant en outre à un capuchon (30) appliqué sur la partie de tête (60c).

10. Elément de connexion du type carte (10) suivant la revendication 7 ou 8, comprenant en outre un capuchon (30) appliqué sur la partie de tête (60c), le capuchon (30) recouvrant une partie des deux plaquettes de protection (22c, 22d).

11. Elément de connexion du type carte (10) suivant l'une quelconque des revendications 1 à 10, dans lequel le ou chaque conducteur électrique (21) est collé à l'intérieur de la rainure (22b) au moyen d'un agent adhésif.

12. Elément de connexion du type carte (10) suivant l'une quelconque des revendications 1 à 11, dans lequel le ou chaque conducteur électrique (21) est un élément découpé fusible.

13. Procédé de fabrication d'un élément de connexion du type carte (10) suivant les revendications 1-12 destiné à être utilisé en coopération avec un élément femelle (50) comportant une borne de connexion électrique (52), caractérisé en ce que le procédé comprend les opérations consistant :
a) à fournir une première plaquette isolante (22) sensiblement rectangulaire présentant des première et seconde faces, des côtés longitudinaux et des côtés latéraux ;
b) à prévoir dans la plaquette (22) une ligne centrale de pliage s'étendant entre les côtés longitudinaux et parallèle aux côtés latéraux ;
c) à former une ouverture allongée (22a) dans la plaquette (22), l'ouverture (22) s'étendant au-dessus d'une partie notable de la ligne centrale de pliage ;
d) à former sur la première face au moins une rainure (22b) s'étendant d'un côté latéral à l'autre côté latéral et sensiblement parallèle aux côtés longitudinaux, la rainure (22b) recoupant l'ouverture allongée (22a) ;
e) à prévoir au moins un conducteur électrique (21) présentant deux extrémités et une partie centrale ;
f) à fixer le conducteur électrique (21) dans la rainure de façon que les extrémités du conducteur électrique (21) soient situées au voisinage des côtés latéraux de la plaquette (22) et que la partie centrale du conducteur électrique (21)s'étende au-dessus de l'ouverture allongée (22a) ;
g) à plier la première plaquette (22), en même temps que le ou chaque conducteur électrique (21), suivant la ligne centrale de pliage, de façon que les deux moitiés de la seconde face soient superposées en étant tournées dans des directions opposées, de sorte qu'il est formé une plaque (20) constituée : d'une partie de pied (60a), contenant les côtés latéraux de la première plaquette (22), par laquelle l'élément de connexion du type carte est inséré dans l'élément femelle (50), d'une partie de tête (60c) contenant l'ouverture allongée (22a), et d'une section de corps intermédiaire (60b) ; et,
h) à appliquer des moyens protecteurs (40) sur la partie de pied (60a).

14. Procédé de fabrication d'un élément de connexion du type carte (10) suivant la revendication 13, comprenant en outre les opérations consistant à fournir une seconde plaquette isolante (22c), sensiblement rectangulaire et comparativement petite, présentant des parties d'articulation (22c1) sur l'un des côtés longitudinaux et de chacun des deux côtés par rapport à la ligne centrale, à plier les secondes plaquettes (22c) sur chaque côté de la première face, et à fixer les secondes plaquettes (22c) sur celle-ci, de façon à former des plaquettes de protection (22c, 22d) appliquées sur la section de corps (60b).

15. Procédé de fabrication d'un élément de connexion du type carte (10) suivant la revendication 14, selon lequel la première plaquette isolante (22) et les secondes plaquettes isolantes (22c) sont réalisées sous forme d'une pièce unique.

16. Procédé de fabrication d'un élément de connexion du type carte (10) suivant l'une quelconque des revendications 13 à 15, le procédé comprenant en outre une opération consistant à fournir un capuchon (30) sur la partie de tête (60c).
